# EUROPEAN PATENT APPLICATION

(11) **EP 3 511 292 A1**
(43) Date of publication of application: **17.07.2019**
(21) Application number: 18151075.1
(22) Date of filing: 10.01.2018
(51) Int. Cl.: B81C 1/00, B81C 99/00, B08B 17/06, B81B 1/00

(54) **A HYDROPHOBIC IMPACT TEXTURED SURFACE AND A METHOD OF MAKING THE SAME**

(71) Applicant: SABIC Global Technologies B.V., 4612 PX Bergen op Zoom (NL)
(72) Inventor: Low, Hong Yee, Singapore 487372 (SG); Dumond, Jarrett J., Singapore 487372 (SG); Ramos Mendez, Alon, Singapore 487372 (SG)
(74) Representative: Modiano, Micaela Nadia

(57) **Abstract**

In an embodiment, an article having an impact textured surface comprises a plurality of vertical pillars; and a plurality of annular impact features; wherein a first portion of the vertical pillars are located in an annulus of the plurality of annular impact features and a second portion of the vertical pillars are located in an area around the plurality of annular impact features; wherein a height of the plurality of annular impact features is at least 10 nanometers greater than a height of the plurality of vertical pillars. In another embodiment, a method of making the article comprises molding the impact textured surface from a mold comprising a plurality of holes and a plurality of annular track features; wherein the plurality of holes corresponds to the plurality of pillars and the plurality of annular track features corresponds to the plurality of annular impact features.

## Description

### BACKGROUND

The development of superhydrophobic surfaces has been demonstrated widely in academic journals due to their unique wetting properties. These surfaces take advantage of microscale and/or nanoscale features on a surface to achieve high water contact angles, for example, of more than 150°. This technology, while having multiple desired end uses, has been slow to enter the commercial markets due to the fragility and poor mechanical robustness of the surfaces that are easily destroyed by even light physical contact or mechanical wear.

Recently, efforts have been made to introduce protective structures that stand above the fine-scale anti-wetting structures to act as load-bearing protrusions so that the anti-wetting structures can remain undamaged after physical contact. One example, as described in Langmuir 2014, 30, 1435-1443, utilizes protective pillars embodied as square pads surrounded by the anti-wetting structures. However, these large flat areas on the surface can reduce or eliminate its superhydrophobic property and can result in decreased contact angle and/or increased sliding angles. In the worst case scenario, when the total area of the square pads is too large, then water droplets passing locally over the square pads can fall out of the Cassie-Baxter wetting state into the Wenzel state becoming pinned to the surface. Thus, there is a trade-off involved between increasing the total area of square pads to increase the protection of the surface versus the need to minimize the total area of square pads to maintain the superhydrophobicity of the surface.

A superhydrophobic surface with improved resilience to impact is therefore desired.

### BRIEF SUMMARY

Disclosed herein is a hydrophobic surface and methods of making the same.

In an embodiment, an article having an impact textured surface comprises a plurality of vertical pillars; and a plurality of annular impact features; wherein a first portion of the vertical pillars are located in an annulus of the plurality of annular impact features and a second portion of the vertical pillars are located in an area around the plurality of annular impact features; wherein a height of the plurality of annular impact features is at least 10 nanometers greater than a height of the plurality of vertical pillars.

In another embodiment, a method of making the article comprises molding the impact textured surface from a mold comprising a plurality of holes and a plurality of annular track features; wherein the plurality of holes corresponds to the plurality of pillars and the plurality of annular track features corresponds to the plurality of annular impact features.

In yet another embodiment, a method of making the mold comprises embossing the plurality of holes onto a template surface at a hole embossing temperature and a hole embossing pressure; and embossing the plurality of annular track features onto the template surface at a track embossing temperature and a track embossing pressure to form the mold; wherein the track embossing temperature is less than the hole embossing temperature and wherein the track embossing pressure is less than the hole embossing pressure.

The above described and other features are exemplified by the following figures and detailed description.

### BRIEF DESCRIPTION OF THE DRAWINGS

Refer now to the figures, which are non-limiting exemplary embodiments, and wherein the like elements are numbered alike. Some of the figures are illustrative of the examples, which are not intended to limit devices made in accordance with the disclosure to the materials, conditions, or process parameters set forth herein.
FIG. 1 is an orthogonal view of an impact textured surface;
FIG. 2 is a cross-sectional view of an impact textured surface;
FIG. 3 is an illustration of an embossing step I;
FIG. 4 is an illustration of an embossing step II;
FIG. 5 is an illustration of a forming step III;
FIG. 6 is a scanning electron microscopy image of the impact textured surface of Example 3;
FIG. 7 is a scanning electron microscopy image of the impact textured surface of Example 3;
FIG. 8 is a scanning electron microscopy image of the impact textured surface of Example 5;
FIG. 9 is a scanning electron microscopy image of the impact textured surface of Example 5;
FIG. 10 is a scanning electron microscopy image of the impact textured surface of Example 7; and
FIG. 11 is a scanning electron microscopy image of the impact textured surface of Example 8.

### DETAILED DESCRIPTION

An article having an impact textured surface was developed that can achieve hydrophobic wetting states as well as an improved resilience to impact. Specifically, the impact textured surface comprises a plurality of vertical pillars that are designed to achieve the hydrophobic wetting state and a plurality of annular impact features that have a height that is at least 10 nanometers greater than a height of the plurality of vertical pillars thereby protecting the plurality of vertical pillars during an impact. Due to the composite feature structure of the impact textured surface, the impact textured surface can support a 10 Newton (N) contacting load without deformation or destruction of the underlying plurality of vertical pillars while maintaining a superhydrophobic surface with a water contact angle of greater than or equal to 90°, or greater than or equal to 130°, or greater than or equal to 150°. A contact angle of greater than or equal to 130° can indicate at least a hybrid Cassie-Baxter/Wenzel wetting state in post-compression and a contact angle of greater than or equal to 150° can indicate a Cassie-Baxter state wetting.

The plurality of vertical pillars can result in a hydrophobic wetting state such that a water droplet on the surface can have a contact angle, *θ*, of greater than or equal to 90°, or greater than or equal to 100°, or greater than or equal to 150°, or 100 to 180°, or 120 to 170°. The impact textured surface can result in a Cassie-Baxter wetting state such that the contact angle of the textured surface, *θ*, is equal to *f*(1 + *cosθ**) - 1, where *f* is the area fraction under the droplet in contact with the surface and *θ** is the Young's Angle of the flat material surface.

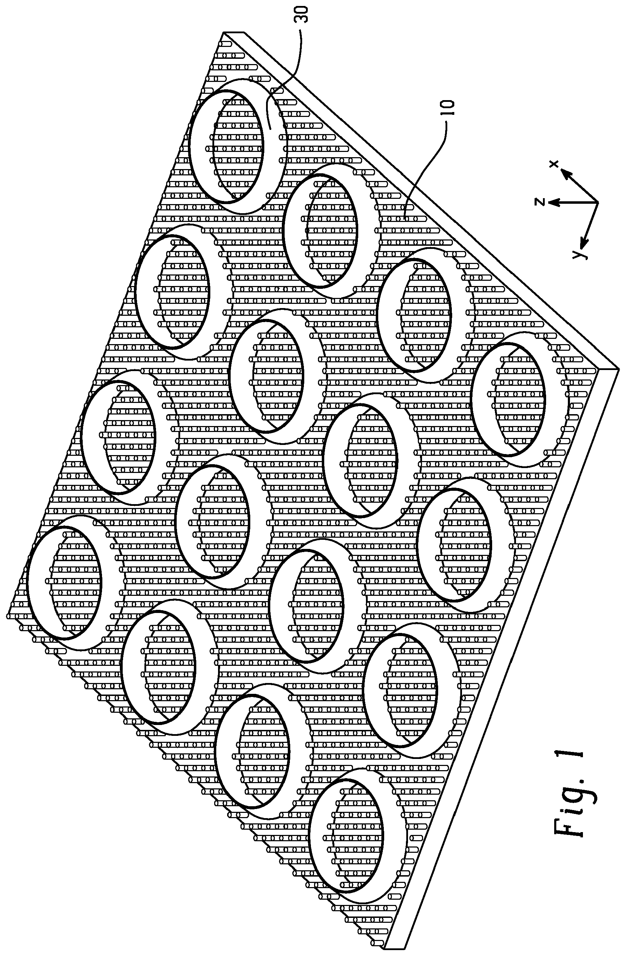

The plurality of vertical pillars are oriented vertically relative to a planar surface of a substrate, for example, FIG. 1 illustrates a plurality of vertical pillars oriented in a z-direction perpendicular to an x-y plane. The plurality of vertical pillars (also referred to generally herein as the vertical pillars) can have one or more of a polygonal cross-section taken on a plane parallel to the surface (for example, a square cross-section, a rectangular cross-section, hexagonal cross-section, and triangular cross-section), a round cross-section (for example, an ovoid cross-section and a circular cross-section), and an irregular cross-section (for example, a star-shaped cross-section). As illustrated in FIG. 1, the cross-section can be cross-section of the pillars taken in the x-y plane. The cross-section of the vertical pillars can be the same or different along the height of the respective pillars. For example, the cross-section of the vertical pillars can be the same along the height of the respective pillars and the side walls of the vertical pillars can be perpendicular to the surface, or within 10° of the perpendicular. Conversely, the cross-section of the vertical pillars can change along the height of the pillars and side walls of the vertical pillars can be angled or curved. For example, the side walls of the vertical pillars can be angled or curved such that the cross-sectional area of the pillars increases with increasing distance (height) from the surface, optionally forming an inverse trapezoidal profile.

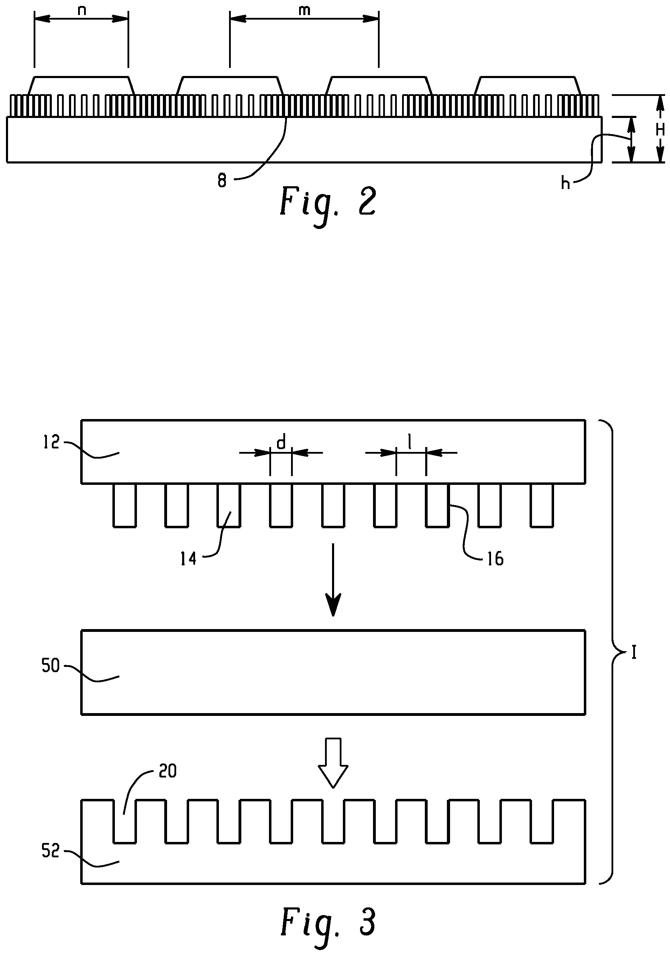

The plurality of vertical pillars each individually can have a longest cross-sectional dimension of the cross-section of 20 nanometers to 50 micrometers, or 1 to 50 micrometers, or 1 to 10 micrometers. The longest cross-sectional dimension can be a diameter (for example, if the cross-section is a circle) or a length (for example, if the cross-section is a square, hexagon, oval, star, or the like). FIG. 3 illustrates a vertical pillar having a longest cross-sectional dimension of d. The plurality of vertical pillars can have a height (measured in a z-direction from the surface) of at least 100 nanometers, or 100 nanometers to 200 micrometers, or 1 to 50 micrometers, or 5 to 15 micrometers. The plurality of vertical pillars can have an aspect ratio of the longest cross-sectional dimension to the height of 0.1 to 10, or 1 to 4. A 100 micrometer squared area can comprise an average of 1 to 1,000 vertical pillars, or 100 to 500 vertical pillars, or 15 to 50 vertical pillars, or 20 to 30 vertical pillars.

The plurality of vertical pillars can be arranged in an ordered array (such as a hexagonal array or a square array) or in a disordered array. The plurality of vertical pillars can have a minimum edge-to-edge spacing of neighboring pillars of 100 nanometers to 200 micrometers, or 5 micrometers to 100 micrometers, or 5 to 40 micrometers. A disordered array can comprise a disordered forest of pillars each independently having at least a minimum of the three neighbors having an edge-to-edge spacing of 100 nanometers to 200 micrometers, or 5 micrometers to 100 micrometers, or 5 to 40 micrometers. FIG. 3 illustrates two neighboring vertical pillars having a minimum edge-to-edge spacing of /.

The impact textured surface comprises a plurality of annular impact features (also referred to herein generally as annular impact features). Upon physical contact with a solid object, the annular impact features can deform by bowing laterally to accommodate the load.

The annular impact features can have a shape (for example, that is a cross-section in a plane parallel to the surface, for example, in a x-y plane as illustrated in FIG. 1) having an annular opening and 0 distinct sides (for example, a circular shape or an ovoid shape) or greater than or equal to 3 sides (for example, a triangular shape, square shape, a rectangular shape, a pentagonal shape, a hexagonal shape, a round shape, or an irregular shape). The annular impact features can have a shape having an annular opening having 0 distinct sides or greater than or equal to 4 sides such that any angle, *α*, if present, between two sides of the shape can be greater than 60°, or 90 to 150°, or 100 to 145°. The cross-sectional shape of the plurality of annular impact features perpendicular to the surface can be rounded and can be free of an angle, *α*. The rounded shape can result in a more favorable contour for water to flow across the surface, reducing the likelihood of the water droplet getting pinned to the surface.

The z-direction height of the annular impact features can be at least 1 micrometer, or 1 micrometer to 1 millimeters (mm), or 1 to 200 micrometers, or 1 to 50 micrometers, or 5 to 17 micrometers. FIG. 2 illustrates a plurality of annular impact features having a height H. The height of the annular impact features can be at least 100 nanometers, or at least 1 micrometer, or 1 to 7 micrometers greater than the height of the plurality of vertical pillars. For example, H - h as illustrated in FIG. 2 can be at least 100 nanometers, or at least 1 micrometer, or 1 to 7 micrometers.

The shape can have a longest dimension, for example, as illustrated in the x-y plane as illustrated in FIG. 1, measured from an outer edge of the shape of the annular impact features and a longest dimension measured from an inner edge of the shape of the annular impact features of 1 micrometer to 1 mm, or 10 to 900 micrometers, or 300 to 900 micrometers; wherein the longest dimension measured from the inner edge is less than the longest dimension measured from the outer edge. When a cross-sectional shape of the plurality of annular impact features perpendicular to the surface comprises two sides forming an apex, then the longest dimension can be 1 micrometer to 1 mm, or 10 to 900 micrometers, or 300 to 900 micrometers. FIG. 2 illustrates an annular impact features having a longest dimension of n.

The plurality of annular impact features can be arranged in an ordered array (for example, a hexagonal array or a square array) or a disordered array. The annular impact features can have a minimum center-to-center spacing of neighboring features of 20 micrometers to 5 mm, or 100 micrometers to 5 mm, 0.5 to 1 mm. FIG. 2 illustrates two neighboring annular impact features having a center-to-center spacing of m.

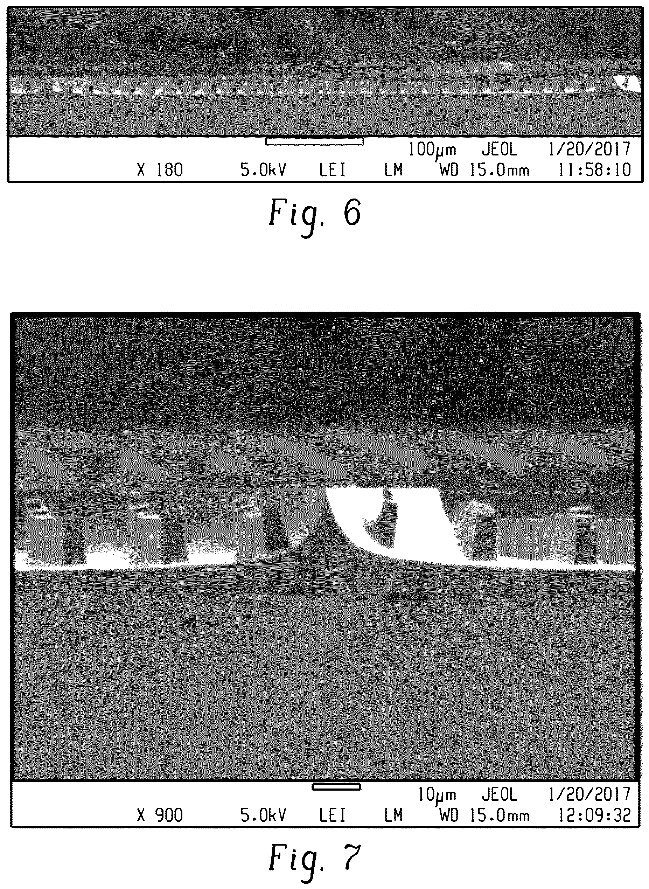

A cross-sectional shape of the plurality of annular impact features perpendicular to the surface, for example, in the z-direction as illustrated in FIG. 1, can be triangular, square, rectangular, or inversely tapered. FIG. 7 is a scanning electron microscopy image of a cross-section perpendicular to the surface of an annular impact feature having an inversely tapered cross-section that comprises two sides forming an apex. This inversely tapered cross-section is often referred to as a sawtooth ring profile.

The sawtooth ring profile can be advantageous to the present impact textured surface. The Cassie-Baxter relation illustrates that increasing the surface area between a water droplet and the textured surface reduces the contact angle, therefore minimizing the contact area between the water droplet and the plurality of annular impact features can minimize any apparent reduction in the contact angle that arises due to the presence of the annular impact features. Taking advantage of the sawtooth ring profile therefore minimizes the flat surface presented to contacting water droplets, which in turn minimizes the degradation of the superhydrophobic effect that occurs when the annular impact features are incorporated into the composite texture.

The impact textured surface can comprise less than or equal to 8 area percent (area%), or 0.1 to 7 area%, or 1 to 6 area% of the plurality of annular impact features. Increasing the area percent of the plurality of annular impact features to an amount of more than 10 area% can result in a significant decrease in the superhydrophobic nature of the surface. Decreasing the area percent of the plurality of annular impact features to an amount of less than 1 area% can result in some decrease in the resilience of the impact textured surface to impact, whereas less than 0.1 area% can result in a significant decrease in the resilience of the impact textured surface to impact.

The impact textured surface can comprise a thermoset or a thermoplastic polymer. As used herein, the term "thermoplastic" refers to a polymer material that is plastic or deformable, melts to a liquid when heated, and freezes to a brittle, glassy state when cooled sufficiently. The polymer can comprise at least one of cyclic olefin polymers (including polynorbornenes and copolymers containing norbornenyl units, for example, copolymers of a cyclic polymer such as norbornene and an acyclic olefin such as ethylene or propylene), fluoropolymers, polyacetals (e.g., polyoxyethylene and polyoxymethylene), poly(C₁₋₆ alkyl)acrylates, polyacrylamides (including unsubstituted and mono-N- and di-N-(C₁₋₈ alkyl)acrylamides), polyacrylonitriles, polyamides (e.g., aliphatic polyamides, polyphthalamides, and polyaramides), polyamideimides, polyanhydrides, polyarylene ethers (e.g., polyphenylene ethers), polyarylene ether ketones (e.g., polyether ether ketones (PEEK) and polyether ketone ketones (PEKK), polyarylene ketones, polyarylene sulfides (e.g., polyphenylene sulfides (PPS)), polyarylene sulfones (e.g., polyethersulfones (PES), polyphenylene sulfones (PPS), and the like), polybenzothiazoles, polybenzoxazoles, polybenzimidazoles, polycarbonates (including homopolycarbonates and polycarbonate copolymers such as polycarbonate-siloxanes, polycarbonate-esters, and polycarbonate-ester-siloxanes), polyesters (e.g., polyethylene terephthalates, polybutylene terephthalates, polyarylates, and polyester copolymers such as polyester-ethers), polyetherimides (including copolymers such as polyetherimide-siloxane copolymers), polyimides (including copolymers such as polyimide-siloxane copolymers), poly(C₁₋₆ alkyl)methacrylates, polymethacrylamides (including unsubstituted and mono-N- and di-N-(C₁₋₈ alkyl)acrylamides), polyolefins (e.g., polyethylenes, such as high density polyethylene (HDPE), low density polyethylene (LDPE), and linear low density polyethylene (LLDPE), polypropylenes, and their halogenated derivatives, and their copolymers, for example, ethylene-alpha-olefin copolymers, polyoxadiazoles, polyoxymethylenes, polyphthalides, polysilazanes, polysiloxanes (silicones), polystyrenes (including copolymers such as acrylonitrile-butadiene-styrene (ABS) and methyl methacrylate-butadiene-styrene (MBS)), polysulfides, polysulfonamides, polysulfonates, polysulfones, polythioesters, polytriazines, polyureas, polyurethanes, vinyl polymers (including polyvinyl alcohols, polyvinyl esters, polyvinyl ethers, polyvinyl halides (for example, polyvinyl chloride), polyvinyl ketones, polyvinyl nitriles, and polyvinyl thioethers). The polymer can comprise at least one of a polycarbonate, an epoxy resin, a silicone polymer (for example, polydimethylsiloxane), and a polyurethane (such as one derived from a step-growth polymerization of a polyurethane mercapto ester).

The impact textured surface can comprise a fluorine-containing, hydrophobic material for enhanced hydrophobicity. The fluorine-containing hydrophobic material can comprise at least one of F₂, SF₆, CF₄, C₄F₈, (CF₃)₂O, CF₃Cl, and CF₃Br. The fluorine-containing hydrophobic material can comprise a fluoropolymer. The fluorine-containing hydrophobic material can comprise a fluoroalkylsilane. The fluorine-containing hydrophobic material can be applied using a plasma treatment, for example, in the presence of one or more of an inert gas, air, O₂, CO₂, N₂, NH₃, NO₂, and NO. The fluorine-containing hydrophobic material can be applied by methods such as sputter coating or spin coating.

The impact textured surface can be formed by molding the impact textured surface from a mold comprising a plurality of holes and a plurality of annular track features; wherein the plurality of holes corresponds to the plurality of pillars and the plurality of annular track features corresponds to the plurality of annular impact features. The molding can comprise depositing a solution comprising the polymer and a solvent onto the mold, and evaporating the solvent. The molding can comprise depositing a monomer and optionally a catalyst onto the mold, and polymerizing the monomer. The molding can comprise depositing a polymer and optionally a cross-linker onto the mold, and cross-linking the polymer. The molding can comprise depositing a polymer above the glass transition temperature of the polymer onto the mold and decreasing the temperature.

A method of forming the mold can comprise using two separate embossing steps. For example, the method can comprise embossing the plurality of holes onto a template surface at a hole embossing temperature and a hole embossing pressure; and embossing the plurality of annular track features onto the same template surface at a track embossing temperature and a track embossing pressure to form the mold. The hole embossing can occur before the track embossing. The track embossing temperature can be less than the hole embossing temperature and the track embossing pressure can be less than the hole embossing pressure.

The hole embossing temperature can be 25 to 400 degrees Celsius (°C), or 100 to 250°C, or 180 to 220°C. The hole embossing pressure is 1 to 5 megapascal (MPa), or 2.5 to 4 MPa. A hole embossing time can be 10 seconds to 10 minutes, or 5 to 10 minutes. The track embossing temperature can be 50 to 100°C, or 65 to 85°C, or 72 to 78°C. The track embossing pressure can be 0.5 to 5 MPa, or 1 to 3 MPa, or 1.5 to 2 MPa. A track embossing time can be 2 to 60 seconds, or 2 to 15 seconds.

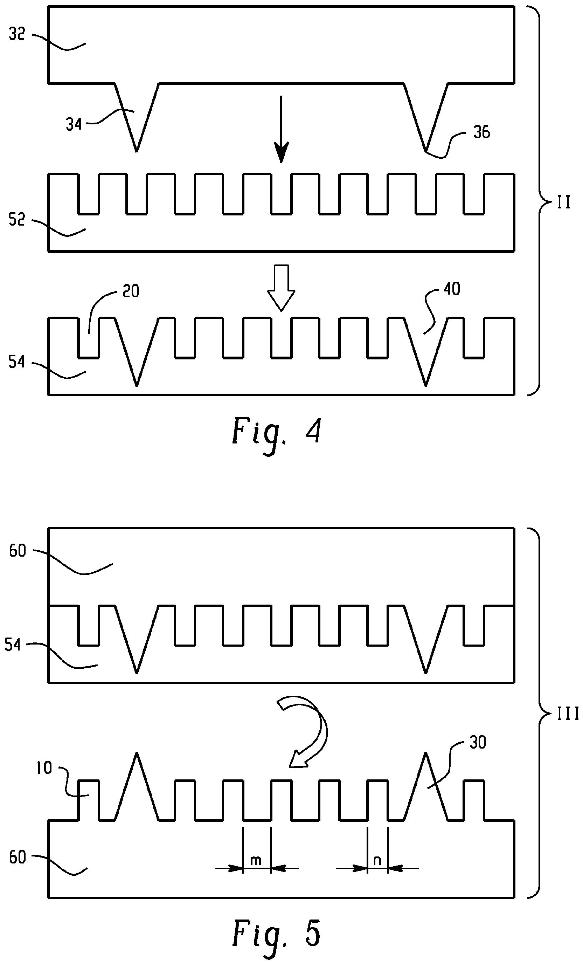

FIG. 3, FIG. 4, and FIG. 5 illustrate a method of making the impact textured surface. FIG. 3 illustrates embossing step I where embossing pillar array 12 comprising a plurality of embossing posts 14 having vertical side-walls 16 is pressed onto initial mold substrate 50 at a hole embossing temperature and a hole embossing pressure to form intermediate substrate 52 comprising a plurality of holes 20. FIG. 4 illustrates embossing step II where embossing annular array 32 comprising a plurality of embossing annuli 34 is pressed onto intermediate substrate 52 at a track embossing temperature and a track embossing pressure to form the mold 54 comprising the plurality of holes 20 and a plurality of annular tracks 40. FIG. 5 illustrates a article forming step III comprising molding impact textured surface 60 from mold 54; wherein the plurality of holes 20 correspond to the plurality of pillars 10 and the plurality of annular tracks 40 correspond to the plurality of annular impact features 30.

The mold can comprise a material with a viscosity-temperature profile suitable for double embossing such that the material can flow at the second embossing temperature to form the annular track features without disrupting the form of the plurality of holes. The mold can comprise a fluoropolymer. The fluoropolymer, for example, for use in the mold, the fluorine-containing hydrophobic material, and the polymer can each independently comprise at least one of poly(ethylene-tetrafluoroethylene) (ETFE), poly(ethylene-chlorotrifluoroethylene) (ECTFE), poly(hexafluoropropylene), poly(tetrafluoroethylene) (PTFE), poly(tetrafluoroethylene-ethylene-propylene), poly(tetrafluoroethylene-hexafluoropropylene) (also known as fluorinated ethylene-propylene copolymer (FEP)), poly(tetrafluoroethylene-propylene) (also known as fluoroelastomer) (FEPM), poly(tetrafluoroethylene-perfluoropropylene vinyl ether), a copolymer having a tetrafluoroethylene backbone with a fully fluorinated alkoxy side chain (also known as a perfluoroalkoxy polymer (PFA)) (for example, poly(tetrafluoroethylene-perfluoroproplyene vinyl ether)), polyvinylfluoride (PVF), polyvinylidene fluoride (PVDF), poly(vinylidene fluoride-chlorotrifluoroethylene), perfluoropolyether, perfluorosulfonic acid, and perfluoropolyoxetane.

The impact textured surface can be an anti-microbial surface, an anti-fouling surface, an anti-icing surface, a self-cleaning surface, an antifogging surface, or a corrosion resistant surface.

The following examples are provided to illustrate articles with enhanced thermal capability. The examples are merely illustrative and are not intended to limit devices made in accordance with the disclosure to the materials, conditions, or process parameters set forth therein.

### Examples

### Example 1: Embossing step I of the embossing pillar array

Ethylene tetrafluoroethylene sheets were embossed with embossing pillar arrays such as arrays A and B described in Table 1. The embossing pillar arrays were square arrays of square or rectangular pillars having vertical pillar side-wall profiles. The embossing step I was performed at a hole embossing temperature of 230°C and a hole embossing pressure of 40 bars (4 MPa) for 5 minutes to form a plurality of holes on the surface of the ethylene tetrafluoroethylene sheets.

| Table 1 | | |
|---|---|---|
| Embossing pillar array | A | B |
| Pillar height (micrometers) | 11 | 11 |
| Pillar diameter (micrometers) | 3 | 5 |
| Edge-to-edge spacing | 15 | 20 |
| Aspect ratio | 3.7 | 2.2 |
| Surface area (cm²) | 4 | 4 |

### Example 2: Embossing step II of the embossing annular array

An embossing annular array was prepared in silica utilizing photolithography and wet etching processes, which is commercially available from NIL Technology ApS. The embossing annular array having a hexagonal array of sawtooth ring grooves is described in Table 2.

| Table 2 | |
|---|---|
| Number of ring-grooves | 388* |
| Ring outer diameter (micrometers) | 650 |
| Ring inner diameter (micrometers) | 570 |
| Center-to-center distance (micrometers) | 1,050 |
| Maximum depth (micrometers) | 20 |
| Aspect ratio | 0.5 |
| Ring area (cm²) | 0.29 |
| Surface area (cm²) | 4 |
| Structure coverage (area%) | 7.44 |

| | |
|---|---|
| adjusted for edge exclusion | |

The ethylene tetrafluoroethylene sheets, A and B, were then embossed with the embossing annular array to form the multi-feature mold substrates comprising a plurality of tracks and holes on the surface of the ethylene tetrafluoroethylene sheets. The embossing step II was performed by sandwiching the respective ethylene tetrafluoroethylene sheet in between the embossing annular array and a flat silicon wafer and embossing at a track embossing temperature of 75°C for 5 seconds at a high temperature ramp rate achieved using a NANONEX NX-2000 system. A pneumatic track embossing pressure of 20 bars (2 MPa) was applied via the silicon wafer during the embossing. The application of the pressure through the silicon wafer allowed for the pressure to concentrate on the annular arrays with little to no pressure being applied to the surface of the hole pattern, thereby preserving the integrity of the pattern.

This embossing step II resulted in a partial emboss of the embossing annular array as the maximum track depth was measured to be only 17 micrometers. When this procedure was performed at a temperature of only 70°C, the maximum track depth was measured to be only 5 micrometers, which was disadvantageously less shallow than the depth of the holes. Furthermore, when this procedure was performed at a temperature of 80°C, deformation of the hole pattern disadvantageously occurred due to full contact of the surface of the embossing annular array onto the surface of the intermediate mold substrate.

### Example 3: Formation of an epoxy impact textured surface

An ultraviolet (UV) curable epoxy resin was then cured on top of the multi-feature mold substrates prepared by Examples 1 and 2 by placing a droplet of NOA 81, commercially available from Norland Products Inc., on top of the multi-feature mold substrate located in the NANONEX NX-2000 system and a glass substrate was lowered onto the droplet. The resin was cured at room temperature at a pressure of 20 bars (2 MPa) for 5 minutes using a 365 nanometer UVLED exposure through the ethylene tetrafluoroethylene multi-feature mold substrate.

FIG. 6 is a scanning electron microscopy image of one of the resultant impact textured surfaces. FIG. 6 shows the formation of both the annular impact features and the plurality of pillars and their relative heights. FIG. 7 is an enlarged view of a cross-section through an annular impact feature. FIG. 7 shows that the annular impact features merged directly into the pillar array. FIG. 7 also shows that there was some deformation of the pillars that were directly in contact with the annular impact features during embossing step II, likely due to these pillars experiencing direct contact pressure at elevated temperature.

### Example 4: Wetting and compression testing of the epoxy impact textured surfaces

The epoxy impact textured surfaces of Example 3 were subjected to dry CF₄/SF₆ reactive ion etch (RIE) plasma treatments, where each gas plasma was sequentially introduced at a flow rate of 10 standard cubic centimeters per minute (sccm) and a pressure of 100 millitorr (mTorr), using a 20 Watt forward bias for 60 seconds at room temperature.

The static contact angle of a water droplet on an unpatterned epoxy surface of NOA 81 and on the epoxy impact textured surfaces before and after surface treatment were determined using goniometry and are shown in Table 3.

| Table 3 | |
|---|---|
| Substrate surface | Static contact angle (°) |
| Unpatterned | 74±2 |
| Before Surface Treatment | 93±4 |
| After Surface Treatment | 167±3 |
| After Compression Testing | 132±3 |

Table 3 shows that a Cassie-Baxter wetting state was achieved after the surface treatment.

Compression testing of the surface treated epoxy impact textured surface was then performed. The compression test was performed by placing the surface treated epoxy impact textured surface onto a poly(dimethyl siloxane) slab, both of which had lateral dimensions of 2 cm x 2 cm, in an INSTRON 5943. A compressive load was exerted onto the sample via a stainless steel upper plate at a rate of 1 Newton per minute to a maximum load of 10 N. The entire mechanical test sequence therefore had a 10 minute duration.

The static contact angle was determined and is also shown in Table 3. Table 3 shows that the hydrophobic nature of the substrate was maintained, though it decreased to a more mixed Cassie-Wenzel wetting state reducing the static contact angle from 167° to 132°. Without being bound by theory, it is believed that this reduction in the contact angle is due to the poor stiffness of the epoxy resulting in deformation of the annular impact features and ultimately in some damage to the underlying pillars. It is noted though that the contacting water droplet maintained a high enough post-compression contact angle to remain in a Cassie/Wenzel transition-state.

### Example 5: Formation of a silicone impact textured surface

A silicone impact textured surface was then prepared by curing SYLGARD 184 on top of the multi-feature mold substrates prepared by Examples 1 and 2 by placing a mixture having a 10:1 weight ratio of prepolymer to cross-linker, commercially available from Dow Corning, on top of the multi-feature mold substrate. The mixture was degassed in a vacuum desiccator for 10 minutes prior to deposition on the multi-feature mold substrate. The siloxane was cured at room temperature for 48 hours.

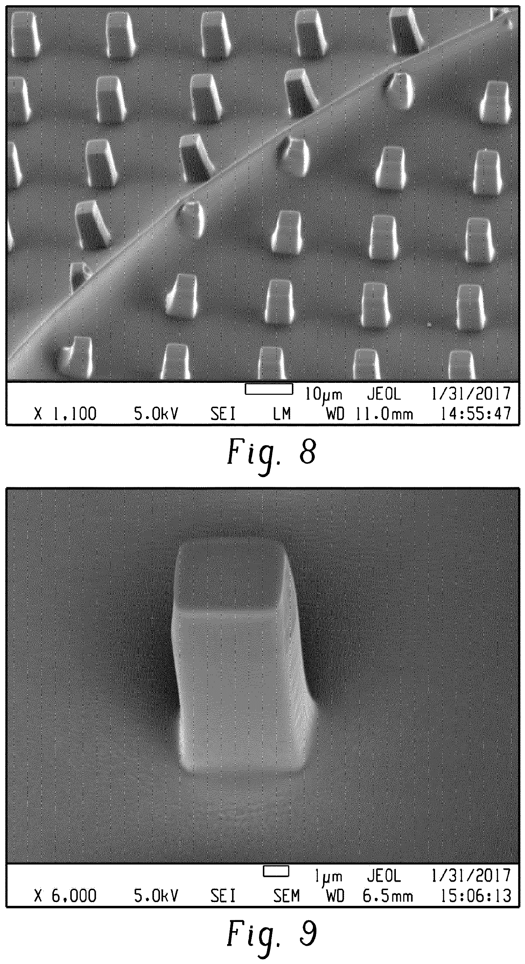

FIG. 8 is a scanning electron microscopy image of a portion of an annular impact feature and the pillars and FIG. 9 is an enlarged image of one of the pillars. These figures show the formation of the two features. It is noted that the features are more rounded then with the epoxy surface as is evident from the tip of the annular impact feature that appears to have a more rounded apex. Without being bound by theory, it is believed that this rounding is due to the lower modulus of the siloxane polymer.

### Example 6: Wetting and compression testing of the siloxane impact textured surfaces

The static contact angle of a water droplet on an unpatterned siloxane surface of SYLGARD 184 prepared in accordance with Example 5 and on the siloxane impact textured surfaces of Example 5 were determined using goniometry and are shown in Table 4.

| Table 4 | |
|---|---|
| Substrate surface | Static contact angle (°) |
| Unpatterned | 109±2 |
| Impact Textured | 159±2 |
| After Compression Testing | n/a |

The contact angle after compression testing was not determined in this study as it is expected that the elastomeric nature of the PDMS will result in a fully recoverable surface, resulting in the post-compression contact angle measurement being very close to, if not the same value, as the pre-compression contact angle of the impact textured measurement.

### Example 7: Formation of a polycarbonate impact textured surface

A polycarbonate impact textured surface was prepared by solvent casting a mixture of 20 wt% LEXAN 8010MC polycarbonate, commercially available from SABIC's Innovative Plastics, business in dichloromethane. The mixture was poured onto a multi-feature mold substrate prepared by Examples 1 and 2 and allowed to stand in a fume hood for 72 hours. A 0.2 millimeter (mm) thick film was formed on the multi-feature mold substrate. The polycarbonate impact textured surface was peeled from the multi-feature mold substrate.

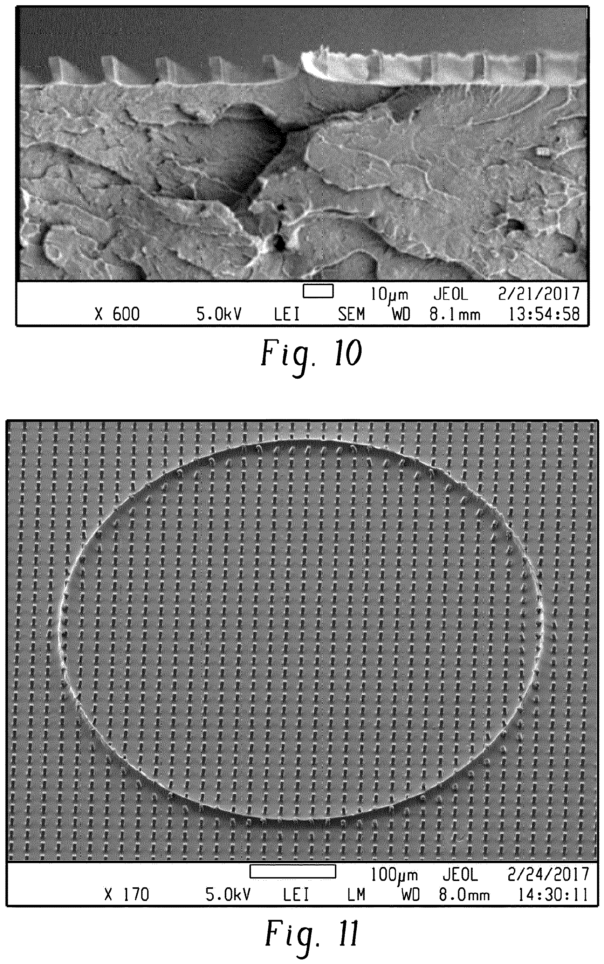

FIG. 10 is a scanning electron microscopy image of one of the resultant impact textured surfaces. FIG. 10 shows clean replicas with high fidelity. While some frilling exists along the apex of the annular impact features, it is believed that this is due to some residual solvent in the annular tracks. The measured heights of the pillars was 10.5 to 11 micrometers, while the annular impact features range in height from 13 to 14 micrometers depending on the extent of tip frilling.

### Example 8: Wetting and compression testing of the polycarbonate impact textured surfaces

The static contact angle of a water droplet on an unpatterned polycarbonate surface prepared in accordance with Example 7 and on the polycarbonate impact textured surfaces of Example 7 were determined using goniometry and are shown in Table 5.

As is seen in the large variability of contact angle of plus or minus 8°, the substrate was associated with a Cassie/Wenzel transition state and the substrate was surface treated to ensure a Cassi-Baxter wetting state. Just as in Example 4, the substrate was subjected to dry CF₄/SF₆ reactive ion etch (RIE) plasma treatments, where each gas plasma was sequentially introduced at a flow rate 10 sccm and a pressure of 100 mTorr, using a 20 Watt forward bias for 60 seconds at room temperature.

| Table 5 | |
|---|---|
| Substrate surface | Static contact angle (°) |
| Unpatterned | 91±2 |
| Before Surface Treatment | 112±8 |
| After Surface Treatment | 162±4 |
| After Compression Testing | 163±5 |

Compression testing of the surface treated polycarbonate impact textured surface was then performed. The compression test was performed using the method described in Example 4.

The static contact angle of the substrate after the compression test was determined and is also shown in Table 5. Table 5 shows that the hydrophobic nature of the substrate was maintained without any observable decrease. In other words, the superhydrophobic nature of the surface was maintained, even after experiencing an impact.

FIG. 11 is an SEM image of the once compressed surface. FIG. 11 shows that while there was some flattening of the pillars proximate to the annular impact features, the remaining pillars remain vertical and were therefore protected from the impact by the annular impact features. It is noted that the force of the compression created a re-entrant profile beneath a curled apex. Without being bound by theory, it is believed that this profile may help to resist wetting due to an increased ability to trap air.

Set forth below are non-limiting embodiments of the present disclosure.
Embodiment 1: An article having an impact textured surface comprising: a plurality of vertical pillars; and a plurality of annular impact features; wherein a first portion of the vertical pillars are located in an annulus of the plurality of annular impact features and a second portion of the vertical pillars are located in an area around the plurality of annular impact features; wherein a height of the plurality of annular impact features is at least 10 nanometers greater than a height of the plurality of vertical pillars.
Embodiment 2: The article of Embodiment 1, wherein the plurality of vertical pillars has one or more of a polygonal cross-section, a round cross-section, and an irregular cross-section.
Embodiment 3: The article of any one or more of the preceding embodiments, wherein the plurality of vertical pillars has a longest cross-sectional dimension of 20 nanometers to 50 micrometers, or 1 to 50 micrometers, or 1 to 10 micrometers.
Embodiment 4: The article of any one or more of the preceding embodiments, wherein the height of the plurality of vertical pillars is at least 100 nanometers, or 100 nanometers to 200 micrometers, or 1 to 50 micrometers, or 5 to 15 micrometers.
Embodiment 5: The article of any one or more of the preceding embodiments, wherein the plurality of vertical pillars has an aspect ratio of 0.1 to 10, or 1 to 4.
Embodiment 6: The article of any one or more of the preceding embodiments, wherein the plurality of vertical pillars has a minimum edge-to-edge spacing of neighboring pillars of 100 nanometers to 200 micrometers, or 5 micrometers to 100 micrometers, or 5 to 40 micrometers.
Embodiment 7: The article of any one or more of the preceding embodiments, wherein the plurality of vertical pillars is arranged in a hexagonal array or a square array.
Embodiment 8: The article of any one or more of the preceding embodiments, wherein the plurality of annular impact features has one or more of a shape having 0 or at least 3 sides.
Embodiment 9: The article of any one or more of the preceding embodiments, wherein at least one of a longest dimension measured from an outer edge of the annular impact features and a longest dimension measured from an inner edge of the annular impact features is 1 micrometer to 1 mm, or 10 to 900 micrometers, or 300 to 900 micrometers; wherein the longest dimension measured from the inner edge is less than the longest dimension measured from the outer edge.
Embodiment 10: The article of any one or more of the preceding embodiments, wherein the height of the plurality of annular impact features is at least 100 nanometers, or at least 1 micrometer, or 1 to 7 micrometers greater than the height of the plurality of vertical pillars.
Embodiment 11: The article of any one or more of the preceding embodiments, wherein the height of the plurality of annular impact features is at least 1 micrometer, or 1 micrometer to 1 mm, or 1 to 200 micrometers, or 1 to 50 micrometers, or 5 to 17 micrometers.
Embodiment 12: The article of any one or more of the preceding embodiments, wherein the plurality of annular impact features has a minimum center-to-center spacing of neighboring features of 20 micrometers to 5 mm, or 100 micrometers to 5 mm, 0.5 to 1 mm.
Embodiment 13: The article of any one or more of the preceding embodiments, wherein a cross-sectional shape of the plurality of annular impact features perpendicular to the surface is triangular, square, rectangular, or inversely tapered.
Embodiment 14: The article of any one or more of the preceding embodiments, wherein the plurality of annular impact features is arranged in a hexagonal array or a square array.
Embodiment 15: The article of any one or more of the preceding embodiments, further comprising a fluorinated surface treatment.
Embodiment 16: The article of any one or more of the preceding embodiments, wherein the impact textured surface comprises at least one of a polycarbonate, a polysiloxane, an epoxy resin, and a polyurethane derived from a polyurethane mercapto ester compound.
Embodiment 17: A method of making the article of any one or more of the forgoing embodiments comprising: molding the impact textured surface from a mold comprising a plurality of holes and a plurality of annular track features; wherein the plurality of holes corresponds to the plurality of pillars and the plurality of annular track features corresponds to the plurality of annular impact features.
Embodiment 18: A method of making the mold of Embodiment 17, comprising embossing the plurality of holes onto a template surface at a hole embossing temperature and a hole embossing pressure; and embossing the plurality of annular track features onto the template surface at a track embossing temperature and a track embossing pressure to form the mold; wherein the track embossing temperature is less than the hole embossing temperature and wherein the track embossing pressure is less than the hole embossing pressure.
Embodiment 19: The method of Embodiment 18, wherein at least one of the hole embossing temperature is 25 to 400°C, or 100 to 250°C, or 180 to 220°C.
Embodiment 20: The method of any one of Embodiments 18-19, wherein the hole embossing pressure is 1 to 5 MPa, or 2.5 to 4 MPa.
Embodiment 21: The method of any one of Embodiments 18-20, wherein a hole embossing time of 10 seconds to 10 minutes, or 5 to 10 minutes.
Embodiment 22: The method of any one of Embodiments 18-21, wherein the track embossing temperature is 50 to 100°C, or 65 to 85°C, or 72 to 78°C.
Embodiment 23: The method of any one of Embodiments 18-22, wherein the track embossing pressure is 0.5 to 5 MPa, or 1 to 3 MPa, or 1.5 to 2 MPa.
Embodiment 24: The method of any one of Embodiments 18-23, wherein a track embossing time is 2 to 60 seconds, or 2 to 15 seconds.
Embodiment 25: The method of any one of Embodiments 18-24, wherein the mold comprises a fluoropolymer.

The compositions, methods, and articles can alternatively comprise, consist of, or consist essentially of, any appropriate materials, steps, or components herein disclosed. The compositions, methods, and articles can additionally, or alternatively, be formulated so as to be devoid, or substantially free, of any materials (or species), steps, or components, that are otherwise not necessary to the achievement of the function or objectives of the compositions, methods, and articles.

The terms "a" and "an" do not denote a limitation of quantity, but rather denote the presence of at least one of the referenced item. The term "or" means "and/or" unless clearly indicated otherwise by context. Reference throughout the specification to "an embodiment", "another embodiment", "some embodiments", and so forth, means that a particular element (e.g., feature, structure, step, or characteristic) described in connection with the embodiment is included in at least one embodiment described herein, and may or may not be present in other embodiments. In addition, it is to be understood that the described elements may be combined in any suitable manner in the various embodiments. The terms "first," "second," and the like, as used herein do not denote any order, quantity, or importance, but rather are used to distinguish one element from another. Unless defined otherwise, technical and scientific terms used herein have the same meaning as is commonly understood by one of skill in the art to which this disclosure belongs.

In general, the compositions, methods, and articles can alternatively comprise, consist of, or consist essentially of, any ingredients, steps, or components herein disclosed. The compositions, methods, and articles can additionally, or alternatively, be formulated, conducted, or manufactured so as to be devoid, or substantially free, of any ingredients, steps, or components not necessary to the achievement of the function or objectives of the present claims.

Unless specified to the contrary herein, all test standards are the most recent standard in effect as of the filing date of this application, or, if priority is claimed, the filing date of the earliest priority application in which the test standard appears.

The endpoints of all ranges directed to the same component or property are inclusive of the endpoints, are independently combinable, and include all intermediate points and ranges. For example, ranges of "up to 25 wt%, or 5 to 20 wt%" is inclusive of the endpoints and all intermediate values of the ranges of "5 to 25 wt%," such as 10 to 23 wt%, etc.

Compounds are described using standard nomenclature. For example, any position not substituted by any indicated group is understood to have its valency filled by a bond as indicated, or a hydrogen atom. A dash ("-") that is not between two letters or symbols is used to indicate a point of attachment for a substituent. For example, -CHO is attached through carbon of the carbonyl group.

All cited patents, patent applications, and other references are incorporated herein by reference in their entirety. However, if a term in the present application contradicts or conflicts with a term in the incorporated reference, the term from the present application takes precedence over the conflicting term from the incorporated reference.

While particular embodiments have been described, alternatives, modifications, variations, improvements, and substantial equivalents that are or may be presently unforeseen may arise to applicants or others skilled in the art. Accordingly, the appended claims as filed and as they may be amended are intended to embrace all such alternatives, modifications variations, improvements, and substantial equivalents.

## Claims

1. An article having an impact textured surface comprising:
a plurality of vertical pillars; and
a plurality of annular impact features;
wherein a first portion of the vertical pillars are located in an annulus of the plurality of annular impact features and a second portion of the vertical pillars are located in an area around the plurality of annular impact features;
wherein a height of the plurality of annular impact features is at least 10 nanometers greater than a height of the plurality of vertical pillars.

2. The article of Claim 1, wherein the plurality of vertical pillars has one or more of a polygonal cross-section, a round cross-section, and an irregular cross-section.

3. The article of any one or more of the preceding claims, wherein the plurality of vertical pillars has a longest cross-sectional dimension of 20 nanometers to 50 micrometers, or 1 to 50 micrometers, or 1 to 10 micrometers.

4. The article of any one or more of the preceding claims, wherein the height of the plurality of vertical pillars is at least 100 nanometers, or 100 nanometers to 200 micrometers, or 1 to 50 micrometers, or 5 to 15 micrometers.

5. The article of any one or more of the preceding claims, wherein the plurality of vertical pillars has an aspect ratio of 0.1 to 10, or 1 to 4.

6. The article of any one or more of the preceding claims, wherein the plurality of vertical pillars has a minimum edge-to-edge spacing of neighboring pillars of 100 nanometers to 200 micrometers, or 5 micrometers to 100 micrometers, or 5 to 40 micrometers.

7. The article of any one or more of the preceding claims, wherein the plurality of vertical pillars is arranged in a hexagonal array or a square array.

8. The article of any one or more of the preceding claims, wherein the plurality of annular impact features has one or more of a shape having 0 or at least 3 sides.

9. The article of any one or more of the preceding claims, wherein at least one of a longest dimension measured from an outer edge of the annular impact features and a longest dimension measured from an inner edge of the annular impact features is 1 micrometer to 1 mm, or 10 to 900 micrometers, or 300 to 900 micrometers; wherein the longest dimension measured from the inner edge is less than the longest dimension measured from the outer edge.

10. The article of any one or more of the preceding claims, wherein the height of the plurality of annular impact features is at least 100 nanometers, or at least 1 micrometer, or 1 to 7 micrometers greater than the height of the plurality of vertical pillars.

11. The article of any one or more of the preceding claims, wherein the height of the plurality of annular impact features is at least 1 micrometer, or 1 micrometer to 1 mm, or 1 to 200 micrometers, or 1 to 50 micrometers, or 5 to 17 micrometers.

12. The article of any one or more of the preceding claims, wherein the plurality of annular impact features has a minimum center-to-center spacing of neighboring features of 20 micrometers to 5 mm, or 100 micrometers to 5 mm, 0.5 to 1 mm.

13. The article of any one or more of the preceding claims, wherein a cross-sectional shape of the plurality of annular impact features perpendicular to the surface is triangular, square, rectangular, or inversely tapered.

14. The article of any one or more of the preceding claims, wherein the plurality of annular impact features is arranged in a hexagonal array or a square array.

15. The article of any one or more of the preceding claims, further comprising a fluorinated surface treatment.

16. The article of any one or more of the preceding claims, wherein the impact textured surface comprises at least one of a polycarbonate, a polysiloxane, an epoxy resin, and a polyurethane derived from a polyurethane mercapto ester compound.

17. A method of making the article of any one or more of the forgoing claims comprising:
molding the impact textured surface from a mold comprising a plurality of holes and a plurality of annular track features; wherein the plurality of holes corresponds to the plurality of pillars and the plurality of annular track features corresponds to the plurality of annular impact features.

18. A method of making the mold of Claim 17, comprising
embossing the plurality of holes onto a template surface at a hole embossing temperature and a hole embossing pressure; and
embossing the plurality of annular track features onto the template surface at a track embossing temperature and a track embossing pressure to form the mold;
wherein the track embossing temperature is less than the hole embossing temperature and wherein the track embossing pressure is less than the hole embossing pressure.

19. The method of Claim 18, wherein at least one of the hole embossing temperature is 25 to 400°C, or 100 to 250°C, or 180 to 220°C; the hole embossing pressure is 1 to 5 MPa, or 2.5 to 4 MPa; a hole embossing time of 10 seconds to 10 minutes, or 5 to 10 minutes; the track embossing temperature is 50 to 100°C, or 65 to 85°C, or 72 to 78°C; the track embossing pressure is 0.5 to 5 MPa, or 1 to 3 MPa, or 1.5 to 2 MPa; and a track embossing time is 2 to 60 seconds, or 2 to 15 seconds.

20. The method of Claim 19, wherein the mold comprises a fluoropolymer.
